(19) Europäisches Patentamt
European Patent Office
Office européen des brevets

(11) **EP 1 803 970 B1**

(12) **EUROPÄISCHE PATENTSCHRIFT**

(45) Veröffentlichungstag und Bekanntmachung des Hinweises auf die Patenterteilung:
**05.10.2011 Patentblatt 2011/40**

(51) Int Cl.:
*F16F 15/027* (2006.01)     *F16C 32/06* (2006.01)
*F15B 21/04* (2006.01)

(21) Anmeldenummer: **06026979.2**

(22) Anmeldetag: **28.12.2006**

(54) **Schwingungsisolationssystem mit pneumatischem Tiefpassfilter**

Vibration isolating system with pneumatic low-pass filter

Système d'isolation de vibrations avec filtre pneumatique passe-bas

(84) Benannte Vertragsstaaten:
**AT BE BG CH CY CZ DE DK EE ES FI FR GB GR HU IE IS IT LI LT LU LV MC NL PL PT RO SE SI SK TR**

(30) Priorität: **30.12.2005 EP 05028713**

(43) Veröffentlichungstag der Anmeldung:
**04.07.2007 Patentblatt 2007/27**

(73) Patentinhaber: **Integrated Dynamics Engineering GmbH**
**65479 Raunheim (DE)**

(72) Erfinder: **Heiland, Peter**
**65479 Raunheim (DE)**

(74) Vertreter: **Blumbach - Zinngrebe**
**Patentanwälte**
**Alexandrastrasse 5**
**65187 Wiesbaden (DE)**

(56) Entgegenhaltungen:
**EP-B1- 0 927 380      WO-A-99/22272**
**DE-A1- 4 233 212      DE-A1- 10 257 810**
**DE-A1- 19 547 308**

## Beschreibung

### Gebiet der Erfindung

Die Erfindung bezieht sich auf ein Gasfeder-Schwingungsisolationssystem nach dem Oberbegriff des Anspruchs 1 und auf ein Verfahren zur Einstellung eines zusätzlichen Strömungswiderstandes.

### Hintergrund der Erfindung

Ein derartiges Schwingungsisolationssystem in Form eines vertikal und horizontal wirksamen Gaslagers wird in EP 0 927 380 B1 = US 6,226,075 B1 (Erfinder: Erik R. Loopstra und Peter Heiland) beschrieben. Sofern es sich bei einem solchen Gaslager um ein System mit entweichendem Gas handelt, ist der Gasverbrauch hoch. Dies gilt insbesondere im Falle klein gebauter Gaslager, die bei hohen Drücken betrieben werden müssen, um die schwere Last, z.B. eines Lithographiegerätes, zu tragen. Solche Lager weisen hohe spezifische Traglastfähigkeiten auf. Die schwingungsisolierende Wirkung ist störempfindlich gegenüber Schwankungen des Versorgungsgasstroms. Auch können in solchen Gaslagersystemen nicht-laminare Gasströmungsverhältnisse auftreten, insbesondere bei hohem Druck. Der Übergang zu nicht laminarem Strömungsverhalten ist mit einem Strömungsabriss verbunden. Dieser verursacht in den Gaslagern ein Kraftrauschen, das als Eigenrauschen des Schwingungsisolators bemerkbar ist.

Zur Gasmengensteuerung, bzw. Gasvolumensteuerung werden in solchen Gaslagersystemen Servoventile eingesetzt. Hierbei wirkt die Ventilöffnung zusammen mit dem Gasvolumen im Gaslager als pneumatischer Tiefpassfilter. Die Druckschrift WO 99/22272 A zeigt eine pneumatische Trägervorrichtung für Lithographiegeräte, die mit einer steuerbaren Gasversorgung ausgestattet ist. Es ist ein pneumatischer Begrenzer beschrieben. Der Begrenzer wird durch eine enge Passage bereitgestellt.

### Zusammenfassung der Erfindung

Der Erfindung liegt die Aufgabe zugrunde, ein Gasfeder-Schwingungsisolationssystem mit wenig Eigenrauschen - d.h. geringen Schwankungen des Gasdrucks - zu schaffen.

Die Erfindung wird in Anspruch 1 definiert.

Im einzelnen weist das Gasfeder-Schwingungsisolationssystem, das ein vertikal und horizontal wirksames Gaslager darstellt und eine Last oder Masse gegenüber einer Unterlage stützt und von Schwingungen entkoppelt, eine Gasquelle, eine Gasstromregeleinrichtung mit einem Servoventil zur Regelung des Gasvolumenstroms an die Gasfeder, eine Zufuhrleitung und einen zusätzlichen Strömungswiderstand in der Zufuhrleitung auf. Die Gasfeder selbst umfasst hauptsächlich eine Basisplatte, ein Führungsgehäuse und einen Kolben, die eine Gas-Druckkammer umschließen. Der Gasdruck innerhalb der Gas-Druckkammer sorgt dafür, dass die Last auf einem gewissen Niveau gehalten wird. Im Falle von Schwankungen des Versorgungsgasdrucks schwankt auch der Gasdruck innerhalb der Gas-Druckkammer. Die Gasströmung durch das Servoventil verursacht ferner Turbulenzen in der Strömung. All dies verursacht ein Kraftrauschen im System. Zwecks Dämpfung dieses Kraftrauschens wird ein zusätzlicher Strömungswiderstand in den Zufuhrweg des Gases zu dem Gaslager eingebaut. Der zusätzliche Strömungswiderstand ist aus einem nichteinstellbaren Laminarrestriktor und einem einstellbaren Restriktor aufgebaut. Die Gesamtanordnung wirkt dann als pneumatischer Tiefpassfilter, d.h. Schwingungen mit einer Frequenz oberhalb einer Abschneidefrequenz werden herausgefiltert. Typischerweise liegt die Abschneidefrequenz des erfindungsgemäßen Tiefpassfilters im mHz Bereich, vorzugsweise im Bereich von 0,05 Hz bis 0,5 Hz.

Ein derartiger Laminarrestriktor oder eine Laminardrossel erhöht den Strömungswiderstand und macht den durch ihn strömenden Gasstrom laminar. Hierdurch wird die Möglichkeit eines Strömungsabrisses und des damit auftretenden Kraftrauschens im System reduziert. In ihrer einfachsten Ausführung besteht ein Laminarrestriktor aus einer einfachen Drosselbohrung, deren Länge den zehnfachen Durchmesser übersteigt.

Gemäß der Erfindung ist der Strömungswiderstand in seinem Widerstandswert einstellbar. Die Einstellbarkeit des Strömungswiderstands bietet den Vorteil, dass es möglich ist, Toleranzen im pneumatischen Pfad zu kompensieren.

Gemäß der Erfindung ist der Strömungswiderstand als Kombination aus einem nichteinstellbaren Laminarrestriktor und einem einstellbaren Restriktor ausgeführt.

Der Laminarrestriktor selbst kann aus porösem Material aufgebaut sein, das Poren vorbestimmter Größe und Länge aufweist, um den durchtretenden Gas-Volumenstrom laminar zu machen.

Das Schwingungsisolationssystem eines schwingungsarm gelagerten Geräts kann mehrere Gasfedern umfassen. Die Leckströme der einzelnen Gasfedern können sich unterscheiden. Um den jeweiligen Druck in den einzelnen Gasfedern individuell einstellen zu können, werden Regler eingesetzt, die den jeweiligen Versorgungsluftstrom auf den jeweils notwendigen Wert einstellen. So kann der Gasdruck einer Gruppe von Gasfedern auf dem jeweils zutreffenden Solldruck gehalten werden.

### Kurze Beschreibung der Zeichnungen

Ausführungsbeispiele der Erfindung werden anhand der Zeichnungen beschrieben.

Dabei zeigt:

Fig. 1　　eine schematische Ansicht des Gasfeder- Schwingungsisolationssystems,

Fig. 2   einen ersten Laminarrestriktor im Längsschnitt,

Fig. 3   einen zweiten Laminarrestriktor,

Fig. 4   eine schematische Darstellung des Kammerdruck- Regelkreises,

Fig. 5   ein elektrisches Ersatzschaltbild für die Einstellung des Laminarrestriktors und

Fig. 6   eine schematische Darstellung des Positions-Regelkreises.

<u>Detaillierte Beschreibung</u>

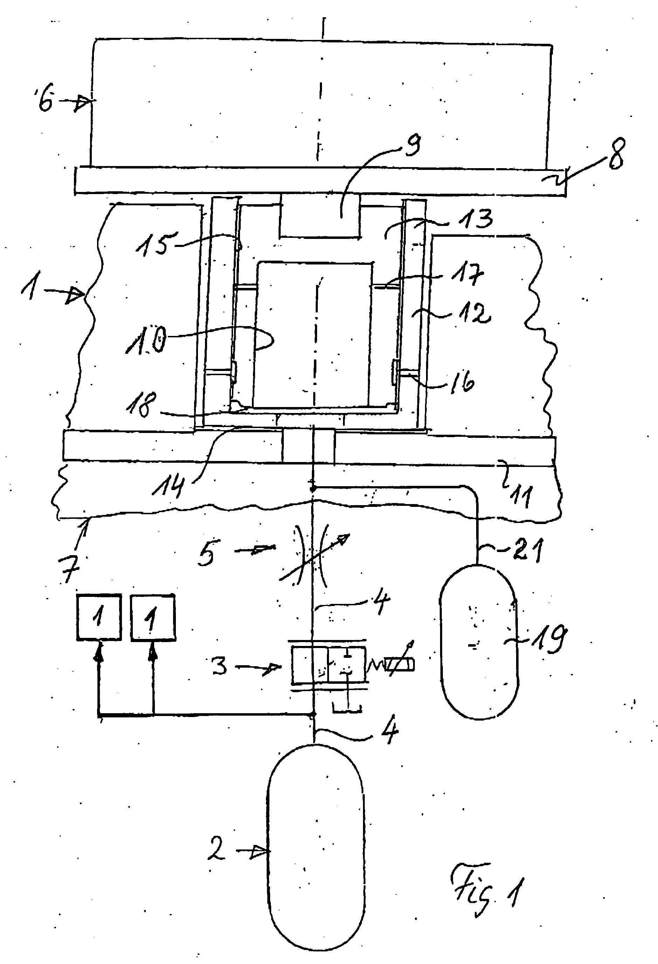

Ein Gasfeder-Schwingungsisolationssystem mit Gasdruckfedern 1 ist in seinem generellen Aufbau in Fig. 1 dargestellt. Die Hauptbestandteile des Gasfeder-Schwingungsisolationssystems zur Stützung und Schwingungsentkopplung einer Last oder Masse 6 gegenüber einer Unterlage 7 sind wenigstens drei Gasdruckfedern 1 und ihre Gasversorgung. Jede Gasdruckfeder weist eine Basisplatte 11, ein Führungsgehäuse 12 und einen Kolben 13 auf, die eine Gasdruckkammer 10 bilden. Die Gasversorgung umfasst eine Gasquelle 2 zur Lieferung von Druckgas an jede Gasfeder 1, eine Gasstrom-Regeleinrichtung 3 zur Regelung des Gasvolumenstroms an die jeweilige Gasfeder 1, und eine Zufuhrleitung 4, über die das Druckgas zur Gasfeder 1 fließt. Die Gasstrom-Regeleinrichtung 3 kann durch ein Servoventil realisiert werden. In der Zufuhrleitung 4 ist ein Strömungswiderstand 5 vorgesehen. Der Strömungswiderstand 5 wird im Folgenden auch als Restriktor bezeichnet. Der Gasdruckkammer 10 wird ein Gasvolumenstrom zugeführt, der infolge des Strömungswiderstandes 5 eine verbesserte Güte aufweist. Die Last 6 ruht auf einer Traglastplatte 8, die über ein jeweiliges Zwischenstück 9 mit dem jeweiligen Kolben 13 verbunden ist. Die Größe der Gasdruckkammer 10 wird auch von der vertikalen Position des Kolbens 13 bestimmt. Aus der Gasdruckkammer 10 entweicht ein Leckgasstrom über Spalte 14, 15 und Bohrungen 16, 17 in und zwischen den Teilen 11, 12, 13.

Der Spalt 14 bildet ein Gaspolster für das Führungsgehäuse 12 und somit ein Lager in horizontaler Richtung. Der Kolben 13 wird zufolge des zwischen Führungsgehäuse 12 und Kolben 13 gebildeten Spaltes oder Gaspolsters 15 in vertikaler Richtung geführt. Die Gaspolster 14 und 15 werden von dem Leckgasstrom gespeist.

Die Gasdruckkammer 10 wirkt bei Beaufschlagung mit Gasdruck als vertikales Gaslager. Die gebildete Steifigkeit der Gasdruckkammer 10 entlang der vertikalen Wirkachse wird bestimmt durch die Größe des eingeschlossenen Gasvolumens, die effektive Wirkfläche 18 (bestimmt durch den äußeren Durchmesser des Kolbens 13), den Isentropenkoeffizient (= Adiabatenkoeffizient) des eingeschlossenen Gases und den beaufschlagten Innendruck im Gasvolumen.

Die Bedeutung der Steifigkeit des Gasfedersystems besteht darin, dass im Falle einer hohen Steifigkeit von außen auf das System einwirkende Schwingungen in höherem Maße an die zu isolierende Last oder Masse 6 weitergegeben werden, als dies bei einer niedrigen Steifigkeit geschieht.

Die Größe des eingeschlossenen Gasvolumens kann durch ein zusätzliches Luftreservoir 19, das über eine Verbindungsleitung 21 mit der Gasdruckkammer 10 verbunden ist, vergrößert werden.

Die zu isolierende Last oder Masse 6 für das erfindungsgemäße Schwingungsisolationssystem liegt typischerweise in der Größenordnung von ca. 500 kg bis 10 Tonnen. Trotz dieser schweren Last besteht die Forderung nach geringer Baugröße des Gaslagers 1, das in der Praxis einen Durchmesser in der Größenordnung von 150 bis 300 mm, gemessen am Außendurchmesser des Kolbens 13, aufweist. Je schwerer die Last 6, um so größer der erforderliche Gasdruck in der Kammer. In der Praxis werden Gasdrücke zwischen 1 und 6 bar angewendet. Ein hoher Gasdruck bedingt jedoch ein höheres Druckgefälle im Leckgasstrom und damit Druckschwankungen im Gaslager 1, was zu Turbulenzen im Leckgasstrom führen kann. Diese Turbulenzen können als Eigenrauschen oder Kraftrauschen des Systems interpretiert werden. Kraftrauschen, d. h. geringfügige Druckschwankungen im Gaslager, kann auch dadurch entstehen, dass der dem Gaslager über die Leitung 4 zugeführte Volumenstrom mit Turbulenzen behaftet ist, wie diese insbesondere durch das Servoventil 3 verursacht werden. Hinzu kommen Druckschwangungen, wie sie durch die Druckerzeugung mittels Pumpen erzeugt werden. Es besteht die Aufgabe, die Traglastfähigkeit des Schwingungsisolationssystems zu maximieren und gleichzeitig Gasverbrauch und Kraftrauschen zu minimieren.

Dies gelingt durch den Einbau eines zusätzlichen Strömungswiderstands (= Restriktors) 5 zwischen Gasquelle 2 und Gasdruckkammer 10. Die Kombination aus Strömungswiderstand 5 und dem in der Gasdruckkammer 10 befindlichen Gasvolumen wirkt als Tiefpassfilter, der eine niedrigere Grenzfrequenz aufweist, als dies in einer Ausführung der Fall wäre, die lediglich das Servoventil 3 aufweist, das ebenfalls als Tiefpassfilter zwischen Gasquelle 2 und Gasdruckkammer 10 wirkt. Es kommt hinzu, dass das Gasvolumen der Gasquelle 2 über die Leitung 4 mit dem Gasvolumen des Gaslagers 1 gekoppelt ist, so dass Druckschwankungen im Gaslager, die sich zum Gasvolumen 2 fortpflanzen, durch den Strömungswiderstand 5 gedämpft werden. Die niedrigere Grenzfrequenz ist gleichbedeutend mit einer stärkeren Tiefpasswirkung, so dass Kraftrauschen im Gasstrom in stärkerem Masse herausgefiltert wird. Ein guter Wert für die Grenzfrequenz oder Abschneidefrequenz des Tiefpassfilters liegt im Bereich von 5 bis 20 mHz.

Aufgrund des typischen Einsatzes derartiger Schwingungsisolationssysteme, z.B. für die Schwingungsisolation photolithographischer Geräte, sind Grenzfrequenzen von 10 Hz bis 0,01 Hz von besonderem Interesse.

Der Strömungswiderstand 5 kann sowohl fest als auch einstellbar sein. Der Einsatz eines Strömungswiderstands 5 mit veränderbar einstellbarem Widerstandswert erlaubt es, Toleranzen in anderen Gliedern des pneumatischen Pfades zu kompensieren.

Zur Vermeidung von Eigenrauschen des Strömungswiderstands 5 sollte dieser als Laminarrestriktor ausgebildet sein.

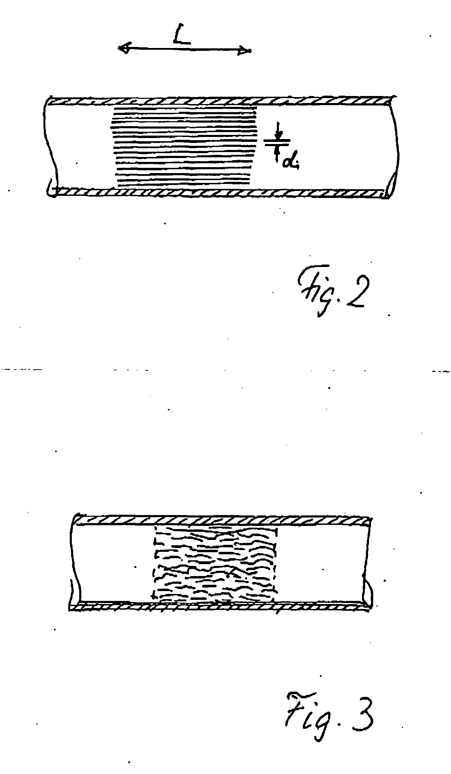

Fig. 2 zeigt einen Laminarrestriktor, der aus einem Bündel von Röhrchen aufgebaut ist, deren Länge L groß gegenüber dem Innendurchmesser d ist (L > 10 d). Alternativ kann der Laminarrestriktor auch nur aus einem Röhrchen aufgebaut sein.

In einer weiteren Ausgestaltung (Fig. 3) wird der Laminarrestriktor aus einem porösen Material, beispielsweise aus einem Sinterkörper, gebildet. Dieses Material weist ein Verhältnis Porengröße zu Porenlänge auf, das laminare Strömung entstehen läßt.

In einer bevorzugten Ausgestaltung der Erfindung werden ein nichteinstellbarer Laminarrestriktor (Fig. 2 oder Fig. 3) und ein einstellbarer Strömungswiderstand, z. B. eine veränderbare Drossel, hintereinander in die Zufuhrleitung 4, und zwar bevorzugt zwischen Gasstrom-Regeleinrichtung 3 und Gasdruckkammer 10, eingebaut.

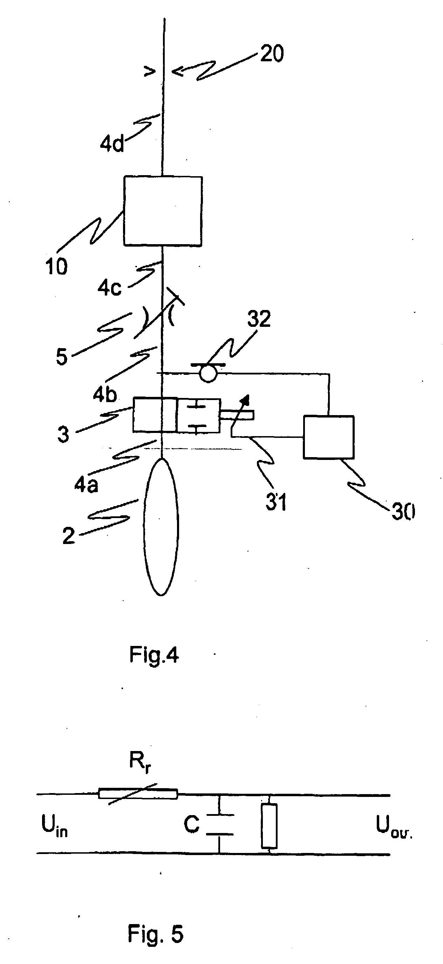

Fig. 4 zeigt den Gasdruck-Regelkreis einer Gasfeder des Gasfeder-Schwingungsisolationssystems. Die GasZufuhrleitung 4 bildet Abschnitte 4a, 4b, 4c und 4d zwischen der Gasquelle 2, dem Servoventil 3, dem Restriktor 5 und der Gasdruckkammer 10. In Fig. 4 wird das Gaslager 1 aus Fig. 1 lediglich durch die Gasdruckkammer 10 repräsentiert. Die Spalte 14, 15 und die Bohrungen 16, 17, durch die der Leckstrom entweicht, bilden zusammengefasst einen Leckstrom-Strömungswiderstand 20. Die Eigenschaften dieses Leckstrom-Strömungswiderstands können für eine gegebene Gasfeder jeweils als konstant betrachtet werden. Zur Bildung des Kammerdruck-Regelkreises wird ein am Leitungsabschnitt 4b angeschlossener Druckluftsensor 32 mit einem Druck-Regler 30 verbunden, der wiederum über eine elektrische Leitung 31 das Servoventil 3 steuert.

Die Rückführung des Regelkreises braucht nicht elektrischer Natur zu sein. Es können andere Arten der Rückführung angewendet werden, wobei eine pneumatisch-mechanische Rückführung von besonderem Vorteil ist.

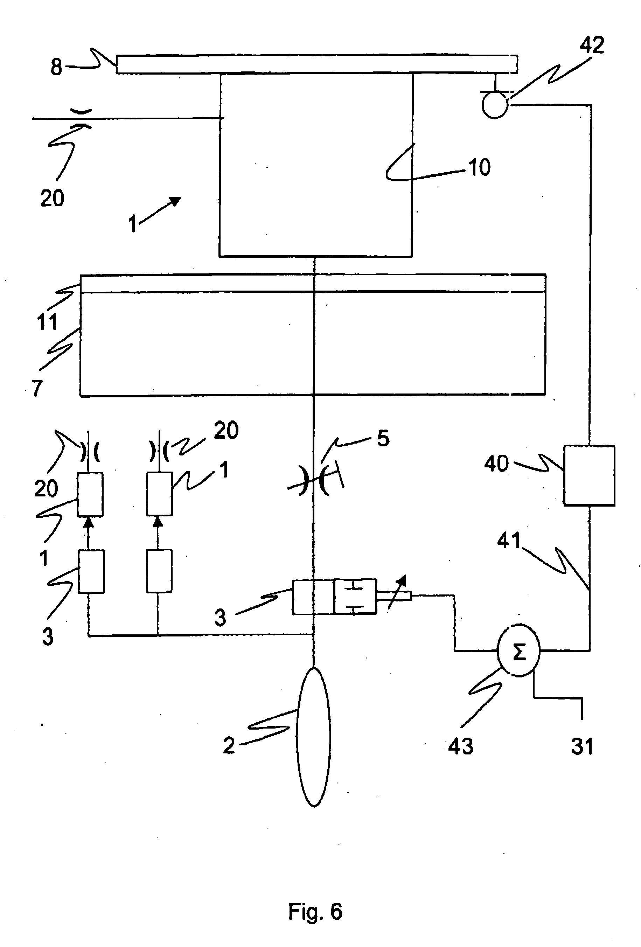

Der Regelkreis dient dazu, den Sollwert des Druckes in der Gasdruckkammer 10 einzuregeln. Zwischen der Gasquelle 2 und der Außenluft befindet sich ein Druckgefälle, das über die Drosseln 3, 5 und 20 absinkt. Somit stellt sich ein Zwischendruck als Istwert in der Gasdruckkammer 10 ein, von dem ein abgeleiteter Wert (Istwert minus Druckabfall an dem Strömungswiderstand 5) am Leitungsabschnitt 4bfestgestellt wird. Der Regler 30 bildet die Differenz zwischen Istwert und Sollwert und steuert das Sensorventil 3 demgemäß, so dass sich der Sollwert in der Gasdruckkammer 10 einstellt. Fig. 6 zeigt den Positions-Regelkreis des Gasfeder-Schwingungsisolationssystems für ein Gasdrucklager 1. Ein Positionssensor 42 tastet die Höhenlage der Traglastplatte 8 ab und meldet diese Position an einen Positionsregler 40, der über eine Steuerleitung 41 und ein Summierglied 43 zur Einspeisung der Stellgröße des Kammerdrucks mit dem Servoventil 3 zu dessen Einstellung verbunden ist. Die Stellung der Traglastplatte 8 hängt von dem Druck in der Gasdruckkammer 10 ab, so dass letztlich der dargestellte Positions-Regelkreis ein übergeordneter Regelkreis zum Kammerdruck-Regelkreis ist. Der Nutzbereich des Reglers 40 reicht von 0 Hz (Gleichstrom) bis zu einer bestimmten Frequenz, der oberen Grenze. Diese obere Grenze kann zwischen 0,05 Hz und 1 Hz und vorzugsweise zwischen 0,1 Hz und 0,5 Hz liegen.

Wie in Fig. 6 angedeutet ist, weist ein schwingungsarm gelagertes Gerät im Allgemeinen mehrere Gasdruckfedern 1 auf, die an der Traglastplatte 8 ansetzen und diese in vertikaler Richtung auf gewissem Niveau halten sollen. Somit werden zur Stützung jedes Geräts mindestens drei Gasdruckfedern 1 benötigt. Jede dieser Gasdruckfedern kann unterschiedlich belastet sein, was dazu führt, dass der Kammerdruck unterschiedlich ist, mit der Folge von unterschiedlichen Leckströmen. Selbst wenn diese Gasdruckfedern 1 konstruktiv gleich sind, gibt es ferner Herstellungs-Abweichungen (sogenannte Toleranzen), die auch dazu führen, dass die Leckströme der Gasdruckfedern unterschiedlich sind. Dies bedeutet unterschiedliche Strömungswiderstände 20 für jedes Lager 1.

Der in Fig. 6 dargestellte Regelkreis wird als pneumatischer Regelkreis bezeichnet.

Es sei angenommen, dass alle Lager 1 gleich belastet werden und auf gleichem Niveau gehalten werden sollen. Durch Einstellung der jeweiligen Strömungswiderstände 5 kann erreicht werden, dass sich gleiche Drücke in jeder Gasdruckkammer 10 eines Geräts einstellen. Dies erfolgt von Hand in Abstimmung mit dem übergeordneten Regelkreis.

Wie im Folgenden beschrieben, ist der Verstärkungsfaktor des pneumatischen Regelkreises eine Funktion des Unterschieds zwischen dem Luftdruck $P_{in}$ am Ausgang des Servoventils 3 und dem Luftdruck $P_{Air}$ im Gaslager 1. Durch die Einstellung des Restriktors 5 kann bei gegebenem Druck $P_{in}$ der Verstärkungsfaktor des pneumatischen Regelkreises auf einem vordefinierten Wert gehalten werden.

Bekanntlich können pneumatische Systeme durch analoge elektrische Systeme modelliert werden. Hierbei entsprechen der Gasdruck der elektrischen Spannung, der Strömungswiderstand dem ohmschen Widerstand, das Luftvolumen der Kapazität und der Luftstrom dem elektrischen Strom.

Das pneumatische System der Erfindung kann nun, wie in Fig. 5 dargestellt, als elektrisches System aufgefasst werden. Die Spannungsquelle mit Ausgangsspannung Uin speist über den Widerstand $R_r$ den Kondensator C und den Widerstand $R_{ab}$. Der Kondensator C liegt parallel zum Widerstand $R_{ab}$. Am Widerstand $R_{ab}$ kann dann die Spannung $U_{out}$ abgegriffen werden. Diese Schaltung wirkt als elektrischer Tiefpassfilter. Die Gesamtimpedanz $Z_{tot}$ dieser Schaltung ist in komplexer Schreibweise dann gegeben durch:

$$Z_{tot} = R_r + \frac{R_{ab}}{I + i\omega R_{ab}C}$$

Für den Strom gilt:

$$I = \frac{U_{in}}{Z_{tot}}$$

Die Ausgangsspannung $U_{out}$ ist daher gegeben durch:

$$U_{out} = U_{in} - R_r I$$

Somit ergibt sich der Verstärkungsfaktor bzw. die Transferfunktion von $U_{in}$ nach $U_{out}$ zu:

$$\frac{U_{out}}{U_{in}} = \frac{1}{1 + \dfrac{R_r}{R_{ab}} + i\omega R_r C}$$

Für Frequenzen unterhalb der Abschneidefrequenz des Tiefpassfilters erhält man aus der vorstehenden Beziehung für den Verstärkungsfaktor:

$$\frac{U_{out}}{U_{in}} = \frac{1}{1 + \dfrac{R_r}{R_{ab}}}$$

Für Frequenzen oberhalb der Abschneidefrequenz des Tiefpassfilters erhält man:

$$\frac{U_{out}}{U_{in}} = \frac{1}{i\omega R_r C}$$

Geht man zum pneumatischen System über, so erkennt man, dass der Verstärkungsfaktor also vom Strömungswiderstand des Restriktors und dem Luftvolumen des Gaslagers bestimmt wird, d.h. für den Verstärkungsfaktor des pneumatischen Systems gilt:

$$\frac{P_{Air}}{P_{in}} = \frac{1}{1 + \dfrac{R_r}{R_{ab}} + i\omega R_r C}$$

Hierbei gelten die folgenden Bezeichnungen:

$P_{in}$:   Luftdruck am Ausgang der Luftversorgung
$P_{Air}$:   Luftdruck im Gaslager
$R_r$:   Strömungswiderstand eines einstellbaren Restriktors, der sich zwischen Luftversorgung und Luftlager befindet.
$C$:   Luftvolumen des Gaslagers
$R_{ab}$:   Strömungswiderstand, den der Leckstrom zu überwinden hat.

Im Gleichgewichtszustand einer mittels Gaslager gelagerten Last muss der Druck im Gaslager gleich dem Gewicht der auf ihm befindlichen Masse M sein. D.h.

Pair * Aeff = M * g, mit $A_{eff}$ als effektiver Querschnittsfläche des Gaslagers und g als der Erdbeschleunigung.

Der wichtigste Unterschied zwischen elektrischen und pneumatischen Systemen besteht darin, dass elektrische Widerstände weitgehend konstant sind, pneumatische Widerstände aber von Druckunterschied und vom Luftstrom abhängen. Für die weitere Betrachtung sei angenommen, dass das pneumatische System durch die folgenden Annahmen hinsichtlich der Abhängigkeiten der Strömungswiderstände beschrieben wird.

$$R_r = \frac{(P_{in} - P_{Air})}{Q}$$

$$R_{ab} = \frac{P_{Air}}{Q}$$

$$P_{Air} = const.$$

Der Luftdruck im Gaslager muss hierbei konstant sein, da sich die zu unterstützende Masse nicht ändert.

Hierdurch ergibt sich der Verstärkungsfaktor oberhalb der Abschneidefrequenz des Tiefpassfilters zu:

$$\frac{P_{Air}}{P_{in}} = \frac{1}{\omega R_r C} = \frac{Q}{\omega\left(P_{in} - P_{Air}\right)C}$$

Da ein pneumatischer Regelkreis vorliegt, wird der Ausgangsdruck der Luftversorgung automatisch so eingestellt, dass der Druck im Inneren des Gaslagers konstant ist.

Der pneumatische Verstärkungsfaktor ist hochsensitiv gegenüber der Stärke des Leckstroms und der Einstellung des Restriktors 5. Eine Erhöhung des Leckstroms führt zu einer Minderung des Verstärkungsfaktors. Eine Minderung des Strömungswiderstands des Restriktors 5 führt zu einer Erhöhung des Verstärkungsfaktors.

Wenn die Lager 1 ungleich belastet werden, jedoch auf gleichem Niveau gehalten werden sollen, kann man ebenfalls durch Einstellung der Strömungswiderstände 5 die passenden Solldrücke in den einzelnen Lagern 1 jeweils einstellen.

Der Ausdruck "Einstellen" ist umfassend zu verstehen und umfasst auch den Ersatz eines verstellbaren und individuell eingestellten Strömungswiderstandes 5 durch eine kalibrierte Laminardrossel 5 mit gleichem Widerstandswert.

Beispiel:

Ein Gasfeder-Schwingungsisolationssystem mit drei Gasfedern 1 und einer Last 6 von 4.000 kg wird mit Druckluft von 5 bar bei einem Gesamtstrom von 100 Nltr/min gespeist. Der Hub des Kolbens 13 zur Bildung des Gaspolsters im Spalt 14 (Fig. 1) betrug 10 $\mu$m. Es ergab sich ein typisches Lagereigenrauschen von ca. 0,5 nm/s$^2$. Mit einem laminaren Strömungswiderstand 5 konnte das Lagereigenrauschen auf bis zu 0,25 mm/s$^2$ gesenkt werden.

**Patentansprüche**

1. Gasfeder-Schwingungsisolationssystem zur Stützung und Schwingungsentkopplung einer Last oder Masse (6) gegenüber einer Unterlage (7), umfassend:

   mindestens eine Gasfeder (1) mit einer Gasdruckkammer (10), welcher ein Gasvolumenstrom zugeführt wird und aus welcher ein Leckstrom entweicht, und mit einer Traglastplatte (8), auf welcher eine Last (6) aufruht;
   eine Gasquelle (2) zur Lieferung von Druckgas an die Gasfeder (1);
   eine Gasstrom-Regeleinrichtung (3, 30, 40) zur Regelung des Gasvolumenstromes an die Gasfeder (1), und

   eine Zufuhrleitung (4), über die das Druckgas zur Gasfeder (1) fließt, wobei, ein zusätzlicher Strömungswiderstand (5) in der Zufuhrleitung (4) vorgesehen ist, um das System auf Tiefpasswirkung einzustellen ist, um sogenanntes Kraftrauschen in der Gasfeder zu dämpfen,
   **dadurch gekennzeichnet, dass** der Strömungswiderstand (5) aus einem nichteinstellbaren Laminarrestriktor und einem einstellbaren Restriktor aufgebaut ist.

2. Gasfeder-Schwingungsisolationssystem nach Anspruch 1 **dadurch gekennzeichnet,**
   **dass** der zusätzliche Strömungswiderstand (5) in der Zufuhrleitung (4) zwischen Gasstrom-Regeleinrichtung (3) und Gasdruckkammer (10) eingerichtet ist.

3. Gasfeder-Schwingungsisolationssystem nach einem der vorstehenden Ansprüche, **dadurch gekennzeichnet,**
   **dass** der Laminarrestriktor aus porösem Material aufgebaut ist, das Poren vorbestimmter Größe und Länge aufweist, um den durchtretenden Gas-Volumenstrom laminar zu machen.

4. Gasfeder-Schwingungsisolationssystem nach einem der vorstehenden Ansprüche, **dadurch gekennzeichnet,**
   **dass** der durch das System gebildete Tiefpass eine Abschneidefrequenz im Bereich von 5 bis 20 mHz aufweist.

5. Gasfeder-Schwingungsisolationssystem nach Anspruch 4, **dadurch gekennzeichnet,**
   **dass** die Gasstrom-Regeleinrichtung (3, 30, 40) einen Regler (40) aufweist, der für einen Nutzbereich mit einer oberen Grenze zwischen 0,05 Hz und 1 Hz ausgelegt ist.

6. Gasfeder-Schwingungsisolationssystem nach Anspruch 5 **dadurch gekennzeichnet,**
   **dass** die obere Grenze des Nutzbereichs zwischen 0,1 Hz und 0,5 Hz liegt.

7. Gasfeder-Schwingungsisolationssystem nach einem der vorstehenden Ansprüche
   **dadurch gekennzeichnet, dass** die Gasfeder (1) eine Basisplatte (11),
   ein Führungsgehäuse (12) und
   einen Kolben (13) umfasst, welche die Gas-Druckkammer (10) umschließen,
   wobei das Führungsgehäuse (12) auf einem zwischen Führungsgehäuse und Basisplatte gebildeten Gaspolster (14) in horizontaler Richtung gelagert ist und der Kolben (13) auf einem zwischen Führungsgehäuse und Kolben gebildeten Gaspolster (15) in vertikaler Richtung geführt ist und die Gaspolster (14, 15) von dem Leckgasstrom gespeist werden.

**8.** Gasfeder-Schwingungsisolationssystem nach einem der vorstehenden Ansprüche, **dadurch gekennzeichnet,**

**dass** mehrere Gasfedern (1) zur Schwingungsentkopplung der Masse (6) gegenüber der Unterlage (7) vorgesehen sind, deren jeweiliger Innendruck auf jeweilig gewünschte Werte gebracht werden sollen, wobei der Leckstrom jeder Gasfeder (1) unterschiedlich sein kann;

**dass** der Innendruck jeder Gasfeder (1) mittels eines Reglers (30, 40) regelbar ist, und

**dass** der zusätzliche Strömungswiderstand (5) jeder Gasfeder (1) individuell auf einen Wert einstellbar ist, der den Zustrom zu der jeweiligen Gasfeder (1) so einstellt, dass der Soll-Innendruck der jeweiligen Gasfeder (1) erreicht wird.

**9.** Verfahren zur Einstellung des zusätzlichen Strömungswiderstands (5) nach einem der Ansprüche 1 - 8, **dadurch gekennzeichnet,**

**dass** die Gasstrom-Regeleinrichtung (3, 30, 40) die Höhenposition der Traglastplatte (8) des Gaslagers (10) bestimmt und in Strömungsrichtung vor dem Strömungswiderstand (5) einen Luftdruck ($P_{in}$) am Ausgang der Luftversorgung einregelt, der infolge des Strömungswiderstands (5) zum Innendruck des Gaslagers (10) abfällt, und

**dass** der Strömungswiderstand (5) so eingestellt wird, dass der Ist-Innendruck gleich dem Soll-Innendruck des Gaslagers wird.

**10.** Verfahren zur Einstellung des zusätzlichen Strömungswiderstands (5) nach vorstehendem Anspruch,

**dadurch gekennzeichnet,**

**dass** der Verstärkungsfaktor der Gasstrom-Regeleinrichtung (3, 30, 40) als Funktion der Differenz des Luftdrucks ($P_{in}$) am Ausgang der Luftversorgung und des Innendrucks ($P_{air}$) im Gaslager (10) durch Einstellung des Strömungswiderstands (5) eingestellt wird.

**Claims**

**1.** Gas spring vibration insulation system for the support and vibration decoupling of a load or mass (6) with respect to a base (7), comprising:

at least one gas spring (1) having a gas pressure chamber (10) which is supplied with a gas volume flow and from which escapes a leakage flow, and having a support load plate (8) on which rests a load (6);

a gas source (2) for supplying pressurised gas to the gas spring (1);

a gas flow regulating device (3, 30, 40) for regulating the gas volume flow to the gas spring (1), and

a supply line (4) via which the pressurised gas flows to the gas spring (1), wherein an additional flow resistor (5) is provided in the supply line (4) in order to set the system to a low pass effect in order to damp so-called force noise in the gas spring,

**characterised in that** the flow resistor (5) is formed from a non-adjustable laminar restrictor and an adjustable restrictor.

**2.** Gas spring vibration insulation system as claimed in Claim 1, **characterised in that** the additional flow resistor (5) in the supply line (4) is arranged between the gas flow regulating device (3) and the gas pressure chamber (10).

**3.** Gas spring vibration insulation system as claimed in any one of the preceding Claims, **characterised in that** the laminar restrictor is formed from porous material which has pores of a predetermined size and length in order to make the throughgoing gas volume flow laminar.

**4.** Gas spring vibration insulation system as claimed in any one of the preceding Claims, **characterised in that** the low pass formed by the system has a cut-off frequency in the range of 5 to 20 mHz.

**5.** Gas spring vibration insulation system as claimed in Claim 4, **characterised in that** the gas flow regulating device (3, 30, 40) comprises a regulator (40) which is designed for a range of use with an upper limit between 0.05 Hz and 1 Hz.

**6.** Gas spring vibration insulation system as claimed in Claim 5, **characterised in that** the upper limit of the range of use is between 0.1 Hz and 0.5 Hz.

**7.** Gas spring vibration insulation system as claimed in any one of the preceding Claims, **characterised in that** the gas spring (1) includes a base plate (11), a guide housing (12) and a piston (13) which surround the gas pressure chamber (10), wherein the guide housing (12) is mounted in the horizontal direction on a gas cushion (14) formed between the guide housing and the base plate, and the piston (13) is guided in the vertical direction on a gas cushion (15) formed between the guide housing and the piston, and the gas cushions (14, 15) are supplied by the leakage gas flow.

**8.** Gas spring vibration insulation system as claimed in any one of the preceding Claims, **characterised in that** several gas springs (1) are provided for the vibration decoupling of the mass (6) with respect to the base (7), wherein the respective inner pressure of the gas springs is to be brought to respectively desired values, wherein the leakage flow of each gas spring (1) can be different; **in that** the inner pressure of each gas spring (1) can be regulated by means of a regulator (30, 40), and **in that** the additional flow resistor (5) of each gas spring (1) can be individually set to a value which adjusts the inflow to the respective gas spring (1) such that the desired inner pressure of the respective gas spring (1) is achieved.

9. Method for adjusting the additional flow resistor (5) as claimed in any one of Claims 1 to 8, **characterised in that** the gas flow regulating device (3, 30, 40) determines the height position of the support load plate (8) of the gas bearing (10) and in the flow direction upstream of the flow resistor (5) adjusts an air pressure ($P_{in}$) at the outlet of the air supply which falls to the inner pressure of the gas bearing (10) as a result of the flow resistor (5), and **in that** the flow resistor (5) is adjusted such that the actual inner pressure becomes equal to the desired inner pressure of the gas bearing.

10. Method for adjusting the additional flow resistor (5) as claimed in the preceding Claim, **characterised in that** the amplification factor of the gas flow regulating device (3, 30, 40) is adjusted as a function of the difference between the air pressure ($P_{in}$) at the outlet of the air supply and the inner pressure ($P_{air}$) in the gas bearing (10) by adjusting the flow resistor (5).

**Revendications**

1. Système d'isolation antivibratile par cartouche à gaz pour le soutien et la dissociation vis-à-vis des vibrations d'une charge ou d'une masse (6) par rapport à un support (7), comprenant :

au moins une cartouche à gaz (1) avec une chambre de pression de gaz (10), à laquelle est amené un flux de volume de gaz et de laquelle s'échappe un flux de fuite, et une plaque de charge portante (8), sur laquelle repose une charge (6) ;
une source de gaz (2) pour la fourniture de gaz sous pression à la cartouche à gaz (1) ;
un dispositif de réglage de flux de gaz (3, 30, 40) pour le réglage du flux volumique de gaz envoyé à la cartouche à gaz (1), et
une conduite d'alimentation (4), par laquelle le gaz sous pression arrive à la cartouche à gaz (1), une résistance à l'écoulement (5) supplémentaire étant prévue dans la conduite d'alimentation (4), afin de régler le système sur l'effet de passe-bas, pour amortir le bruit de force dans la cartouche à gaz, **caractérisé en ce que** la résistance à l'écoulement (5) est constituée d'un restricteur laminaire non réglable et d'un restricteur réglable.

2. Système d'isolation antivibratile par cartouche à gaz selon la revendication 1, **caractérisé en ce que** :

la résistance à l'écoulement (5) supplémentaire dans la conduite d'alimentation (4) est présente entre le dispositif de réglage de flux de gaz (3) et la chambre de pression de gaz (10).

3. Système d'isolation antivibratile par cartouche à gaz selon l'une quelconque des revendications précédentes, **caractérisé en ce que** :

le restricteur laminaire est conçu à base de matériau poreux, qui présente des pores de grandeur et de longueur prédéfinies, afin de rendre laminaire le flux volumique de gaz traversant.

4. Système d'isolation antivibratile par cartouche à gaz selon l'une quelconque des revendications précédentes, **caractérisé en ce que** :

le passe-bas formé par le système présente une fréquence de coupure de l'ordre de 5 à 20 mHz.

5. Système d'isolation antivibratile par cartouche à gaz selon la revendication 4, **caractérisé en ce que** :

le dispositif de réglage de flux de gaz (3, 30, 40) présente un régulateur (40), qui est conçu pour une plage utile avec une limite supérieure comprise entre 0,05 Hz et 1 Hz.

6. Système d'isolation antivibratile par cartouche à gaz selon la revendication 5, **caractérisé en ce que** :

la limite supérieure de la plage utile se situe entre 0,1 Hz et 0,5 Hz.

7. Système d'isolation antivibratile par cartouche à gaz selon l'une quelconque des revendications précédentes, **caractérisé en ce que** :

la cartouche à gaz (1) comprend une plaque de base (11), un carter de guidage (12) et un piston (13), qui entourent la chambre de pression de gaz (10),
le carter de guidage (12) étant monté sur un matelas de gaz (14) formé entre le carter de guidage et la plaque de base dans le sens horizontal et le piston (13) étant guidé sur un matelas de gaz (15) formé entre le carter de guidage et le piston dans le sens vertical et les matelas de gaz (14, 15) étant alimentés par le flux de gaz de fuite.

**8.** Système d'isolation antivibratile par cartouche à gaz selon l'une quelconque des revendications précédentes, **caractérisé :**

en ce que plusieurs cartouches à gaz (1) sont prévues pour la dissociation vis-à-vis des vibrations de la masse (6) par rapport au support (7), dont les pressions intérieures respectives doivent être amenées à des valeurs respectivement souhaitées, le flux de fuite de chaque cartouche à gaz (1) pouvant être différent ;
en ce que la pression intérieure de chaque cartouche à gaz (1) peut être réglée au moyen d'un régulateur (30, 40), et
en ce que la résistance à l'écoulement (5) supplémentaire de chaque cartouche à gaz (1) peut être réglée individuellement sur une valeur, qui règle le flux arrivant à la cartouche à gaz (1) respective de telle sorte que la pression intérieure théorique de la cartouche à gaz (1) respective soit atteinte.

**9.** Procédé pour régler la résistance à l'écoulement (5) supplémentaire selon l'une quelconque des revendications 1 à 8, **caractérisé :**

en ce que le dispositif de réglage de flux de gaz (3, 30, 40) détermine la position en hauteur de la plaque de charge portante (8) du palier de gaz (10) et intègre dans le réglage, dans le sens d'écoulement en amont de la résistance à l'écoulement (5), une pression d'air ($P_{in}$) à la sortie de l'alimentation en air, qui décroît du fait de la résistance à l'écoulement (5) par rapport à la pression intérieure du palier de gaz (10), et
en ce que la résistance à l'écoulement (5) est réglée de telle sorte que la pression intérieure réelle est égale à la pression intérieure théorique du palier de gaz.

**10.** Procédé pour régler la résistance à l'écoulement (5) supplémentaire selon la revendication précédente, **caractérisé en ce que :**

le facteur d'amplification du dispositif de réglage du flux de gaz (3, 30, 40) est réglé en fonction de la différence entre la pression d'air ($P_{in}$) à la sortie de l'alimentation en air et la pression intérieure ($P_{air}$) dans le palier de gaz (10) par réglage de la résistance à l'écoulement (5).

Fig. 1

*Fig. 2*

*Fig. 3*

Fig.4

Fig. 5

Fig. 6

**IN DER BESCHREIBUNG AUFGEFÜHRTE DOKUMENTE**

**In der Beschreibung aufgeführte Patentdokumente**

- EP 0927380 B1
- US 6226075 B1, Erik R. Loopstra und Peter Heiland
- WO 9922272 A